(19) Europäisches Patentamt
European Patent Office
Office européen des brevets

(11) EP 4 296 221 A1

(12) **EUROPEAN PATENT APPLICATION**

(43) Date of publication:
**27.12.2023 Bulletin 2023/52**

(21) Application number: **22180506.2**

(22) Date of filing: **22.06.2022**

(51) International Patent Classification (IPC):
**B81B 3/00** (2006.01)

(52) Cooperative Patent Classification (CPC):
**B81B 3/007;** B81B 2201/025; B81B 2201/0285;
B81B 2203/0109; B81B 2203/053

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Infineon Technologies AG**
**85579 Neubiberg (DE)**

(72) Inventors:
• **BASAVANNA, Abhiraj**
**81739 München (DE)**

• **BOGNER, Andreas**
**80797 München (DE)**
• **BRETTHAUER, Christian**
**81675 München (DE)**

(74) Representative: **Hersina, Günter et al**
**Schoppe, Zimmermann, Stöckeler Zinkler, Schenk & Partner mbB Patentanwälte**
**Radlkoferstrasse 2**
**81373 München (DE)**

(54) **SEMICONDUCTOR DEVICE**

(57) There is disclosed mainly a semiconductor device having a deformable membrane, e.g. for the measurement of at least one of an acceleration, a vibration, or a pressure. The membrane (12) has an supporting connection with a supporting structure (60) which includes at least one elastic supporting connection. There are also disclosed a sensor device including the semiconductor device, and methods for manufacturing the semiconductor device and the sensor device.

Fig. 1a

Fig. 1b

EP 4 296 221 A1

## Description

## Technical field

Examples here disclosed mainly relate to a semiconductor device having a deformable membrane, e.g. for the measurement of at least one of an acceleration, a vibration, or a pressure. Examples also relate to a sensor device including the semiconductor device. Examples also refer to a method for manufacturing the semiconductor device and the sensor device. The semiconductor device may be a micro electro-mechanical system, MEMS.

## Background

A MEMS semiconductor device with a deformable membrane, for the measurement of an acceleration, a vibration, or a pressure, may have one mass element attached to the membrane. Under the effect of a pressure, acceleration or vibration, the mass element may move, thereby deforming the membrane. Information on the membrane's deformation is provided through an electric signal, e.g. through a capacitive, piezoelectric, or piezoresistive technique.

In particular for high vibration sensitivity and low noise the mass element shall have a large mass. Unfortunately, the larger the mass, the lower the robustness. In addition the mass radius affects the mechanical stiffness. In order to increase mass without changing the stiffness, the mass element should have an elongated shape. However, with this solution the barycenter (center of mass) of the mass element is distant from the membrane, which tends to cause unwanted tilting modes. The tilting modes cause the membrane not to vibrate properly, and insert unwanted resonances in the electric signal.

Moreover, the techniques (e.g. etching, such as Bosch etching) normally used for making the mass element often do not have enough precision to make so elongated mass elements. Therefore, either different techniques should be used, or the stockiness of the mass element should be increased. However, this increases stiffness, exacerbating the issues discussed above.

Techniques are pursued for coping with this inconvenients.

## Summary

In accordance to an example, there is proposed a semiconductor device comprising:

a deformable membrane;
a support structure, the deformable membrane being connected to the support structure through at least one supporting connection, wherein the at least one supporting connection includes at least one elastic supporting connection;
at least one electric contact to obtain an electric signal indicative of the deformation of the deformable membrane; and
at least one mass element attached to, or integral with, the deformable membrane.

Thanks to the elasticity of the supporting connection, the stiffness is reduced, the displacement of the at least one mass element can be increased, without notwithstanding elongating its shape too much.

In accordance with an aspect, the deformable membrane may be partially inserted in (or may be partially integral with) the support structure. The deformable membrane may be partially separated from the support structure so that at least one aperture is defined by the deformable membrane and the support structure, thereby forming an elastic supporting connection. The deformable membrane may be partially enclosed in (or at least partially in contact with) the support structure, while the membrane border may also be separated (for some portions) from the support structure. This may be one technique which permits to increase elasticity of the supporting connection of the deformable membrane. A fluid communication between two environments separated by the membrane is also achieved. It has been noted that it is therefore possible to achieve an adequate ventilation between the two environments separated by the deformable membrane.

In accordance with an aspect, at least one mass element may partially overlap with at least one aperture. Accordingly, the at least one aperture covered by the mass element results partially (but not totally) covered by the mass element. It has been understood that, accordingly, the stockiness of the shape of the at least one mass element may be increased (and the elongation is therefore reduced), thereby reducing the tilting effects even more, without increasing stiffness.

In accordance with an aspect, there may be provided at least one flap separated from the deformable membrane and supported by the support structure, each flap partially occupying, or otherwise overlapping with, at least one aperture. The flap may protrude from the supporting structure towards the deformable membrane, without contacting the membrane. Accordingly, the area of the aperture which permits the ventilation between the two environments separated by the membrane can be regulated.

In accordance with an aspect, there may be provided one single mass element (e.g., in central position of the deformable membrane). If the mass element is single in number, in theory tilting modes may occur. However, by reducing the elongation (but keeping the mass high, e.g. in consequence of the protrusion over the aperture and/or by increasing stockiness of the shape of the mass element), even one single mass element can become appropriated. In some cases, it is possible to regulate the mass element by making a central hole in the mass element, so as to achieve the desired mass necessary for the particular requested fundamental mode resonance.

In accordance with an aspect, at least one mass element may be in metal material. This is extremely advantageous, because metals have higher density than materials traditionally used for the mass elements. Hence, the elongation may be further reduced, and the tilting modes are even further reduced. It is the elasticity of the supporting connection which permits to use metal, which was traditionally avoided because of the problems of stiffness.

In accordance with an aspect, the at least one mass element may have a thickness less than 300 $\mu$m (micrometers), in particular when in semiconductive material (e.g. silicon-based material), thereby achieving an appropriate stockiness, further reducing the tilting modes. When in metal material, the at least one mass element may have a thickness less than 100 $\mu$m (micrometers), or more preferably less than 50 $\mu$m (micrometers), or even more preferably between 1.5 $\mu$m (micrometers) and 30 $\mu$m (micrometers), and even more preferably between 1.5 $\mu$m (micrometers) and 20 $\mu$m (micrometers).

In accordance with an aspect, the at least one mass element may be subjected to a movement to generate, as a resultant, at least one translatorily oscillating mode (piston mode), oscillating according to a line transverse (e.g. normal) to the deformable membrane (to the line of the deformable membrane when the deformable membrane is in its unsolicited position). The piston mode is preferred over the tilting mode. In accordance with an aspect, the center of mass (barycenter) of the mass element is in centered position of deformable membrane. In case of the plurality of mass elements, the center of mass is the center of mass of all the mass elements together (which may be outside of any of the mass elements), and is in central position of the membrane.

According to an aspect, the deformable membrane may include corrugations (e.g. placed between the aperture(s) and the mass element, to increase elasticity.

According to an aspect, the semiconductor device may comprise a capacitor with variable capacitance and with at least one first electrode and at least one second electrode. The first electrode may include the deformable membrane. The capacitance is varied in consequence of the membrane's deformation conditioned by the movement of the plurality of mass elements. The electric signal is therefore conditioned by the capacitance, and, accordingly, by the membrane's deformation (and therefore follows the acceleration, vibration, pressure experienced by the deformable membrane and the at least one mass element).

According to an aspect, the at least one second electrode may include a backplate (or a second electrode) keeping in place the deformable membrane through at least one support post. The backplate (or the second electrode) may be stiff. In operation, the deformation will interest the deformable membrane, while the backplate (or the second electrode) will not move.

According to an aspect, the deformable membrane may be include a piezoelectric deformable membrane (e.g. at least one piezoelectric layer) electrically connected to the at least one electric contact. The deformation of the deformable membrane (and in particular of the at least one piezoelectric layer), conditioned by the movement of the plurality of mass elements, causes the variation of the electric signal. The electric signal is therefore conditioned by the deformation of the deformable membrane (and therefore follows the acceleration, vibration, pressure experienced by the deformable membrane and the mass elements).

According to an aspect, the deformable membrane may operate as a resistor with variable resistance (e.g. in piezoresistive material), being subjected to a flow of electric current. The electric signal is conditioned by the deformation of the deformable membrane conditioned by the movement of the at least one mass element. Therefore, the resistance follows the acceleration, vibration, pressure experienced by the deformable membrane and the mass elements.

According to an aspect, there may be provided a sensor device comprising a semiconductor device as above or below, further comprising:

> analog-to-digital circuitry to convert the electric signal indicative of the deformation of the deformable membrane onto a digital version; and
> at least one digital measurer to obtain, from the digital version of the electric signal, a measurement of at least one pressure, vibration, and acceleration.

The sensor device, which may be, or be part of, a voice pickup unit (VPU), for example, may also include a plurality of semiconductor devices (e.g. as above) with different displacements, weights, shapes, of the mass elements (e.g., each of them being particularly sensitive to a particular acceleration range, vibration range, or pressure range, so that a plurality of different electric signals are obtained simultaneously, and the acceleration, vibration, or pressure is measured with increased precision through signal processing involving the different electric signals obtained simultaneously.

According to an aspect, there is provided a method for manufacturing a semiconductor device, the method comprising:

> making a support structure, and a deformable membrane supported by the support structure through at least one supporting connection, in such a way that the at least one supporting connection includes at least one elastic connection, the at least one mass element being attached to (e.g. integral with, or clamped to, held by, supported by, etc.) the deformable membrane; and
> electrically connecting the deformable membrane to a circuitry, the circuitry being configured to acquire an electric signal indicative of the deformation of the deformable membrane conditioned by the movement of the at least one mass element.

According to an aspect, the at least one mass element may be in metal material, and may be obtained through metal plating or physical vapor deposition. Layer thickness defined by metal plating and physical vapor deposition are more precise than etching to a certain layer thickness.

According to an aspect, the semiconductor device may be a capacitor with variable capacitance, the capacitor having a first electrode and second electrode, the first electrode including the deformable membrane. The method may include making the second electrode before, and in a more internal position than, the deformable membrane, the method including making the at least one mass element more external than the deformable membrane (e.g. using layer growth or another technique).

## Figures

Fig. 1a shows a semiconductor device according to a first example and seen according to protrusion direction.
Fig. 1b shows the semiconductor device of Fig. 1a in a planar directions.
Fig. 2 shows another example of a semiconductor device according to a protrusion direction.
Fig. 3 shows another example of a semiconductor device according to a protrusion direction.
Fig. 4a shows a view in perspective of elements of an example (which can be one of the examples of Figs. 1a-3).
Fig. 4b shows a view in the planar directions of the elements of Fig. 4a.
Fig. 4c shows a view along the protrusion direction of the element of Figs. 4a and 4b.
Fig. 4d shows a view in perspective and partially cross-sectioned of the element of Figs. 4a-4c with an additional supporting structure.
Fig. 4e shows a view along planar directions of the elements of Fig. 4d.
Fig. 4f shows a view in perspective of the elements of Figs. 4d and 4e.
Figs. 5a and 5b show examples of configurations of a membrane and at least one mass element according to examples.
Figs. 6a and 6b show elements of a semiconductor device which may be one of Figs. 1a, 1b or 2 in partially cross-sectioned perspectives.
Fig. 7 shows an electric connection of a device according to the present document.
Fig. 8a shows another example of a device according to the present document in a partially cross-sectioned perspective.

Fig. 8b shows the device of Fig. 8a in a view according to planar directions.
Fig. 9 shows a cross-sectional view in a protrusion direction of a structure (e.g. chip) comprising a device according to the present document.
Fig. 10a shows a view in a planar direction of another example of the semiconductor device.
Fig. 10b shows a view in the protrusion direction of the example of Fig. 10a.
Fig. 11a shows a view in a planar direction of another example of the semiconductor device.
Fig. 11b shows a view in the protrusion direction of the example of Fig. 11a.
Fig. 12 shows another example in the protrusion direction of a semiconductor device.
Fig. 13a shows an operation of a semiconductor device according to the conventional art.
Fig. 13b shows an operation of a device according to the present document.
Fig. 14a shows a simulation of the behavior of a semiconductor device in tilting mode.
Fig. 14b shows the behavior of a device in piston mode.
Fig. 15a shows a view in a protrusion direction of another example of the semiconductor device.
Fig. 15b shows a view in planar directions of the example of Fig. 10a.

## Examples

Examples of micro electro mechanical system (MEMS) devices are discussed here below.

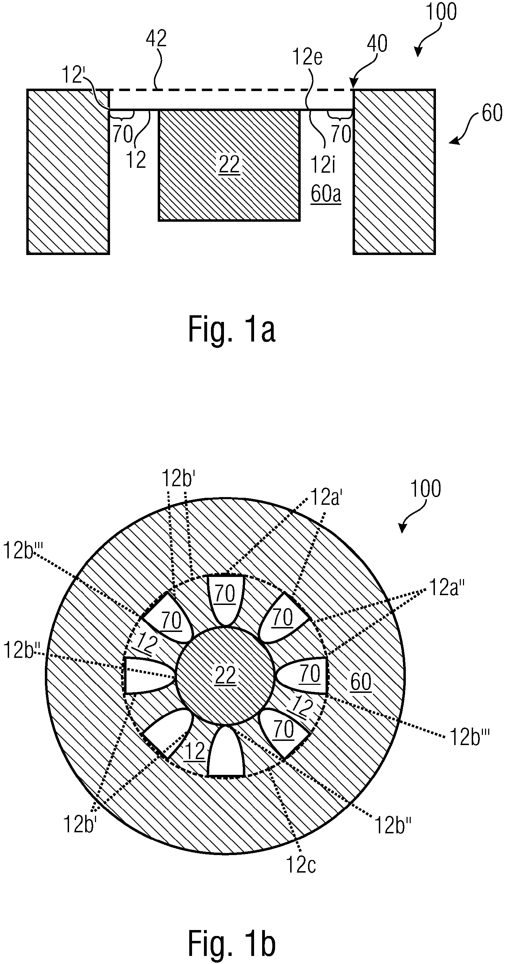

Figs. 1a and 1b show a semiconductor device 100. Fig. 1b shows the extension of the semiconductor device 100 along two planar directions (the two planar directions form a plane, or are parallel to a plane, on which the membrane, when unsolicited, extends). Fig. 1a shows the extension of the semiconductor device 100 along one planar direction (represented as horizontal), along which a deformable membrane 12 extends, and a protrusion direction (represented as vertical), along which at least one mass element 22 protrudes. The semiconductor device 100 may be (or be part of) part of a voice pickup unit. The semiconductor device 100, in this case, operates as a capacitor with variable capacitance (it will be shown that there is the possibility of implementing the examples by operating a semiconductor device according to different techniques, e.g. piezoelectric, piezoresistive, etc.).

The deformable membrane 12 may be subjected to deformation (in particular by being deformed along the protrusion direction). The membrane 12 may sustain the at least one mass element 22. The semiconductor device 100 may have at least one or more mass elements 22 (one single mass element in the example of Figs. 1a and 1b). Each mass element 22 may be, in some examples, a cylinder (or a prism) with height (thickness) elongated in the protrusion direction, and radius (or face) being elongated in at least one of the planar directions (other shapes are possible). The at least one mass element 22 may operate as inertial mass, providing a particular inertia to the membrane 12 (the particular inertia may be associated to a particular acceleration, vibration, or pressure to be sensed).

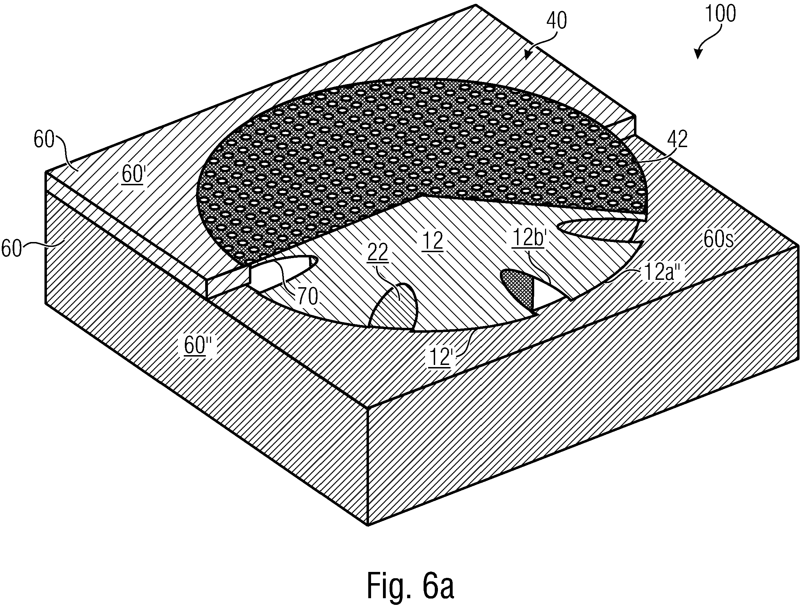

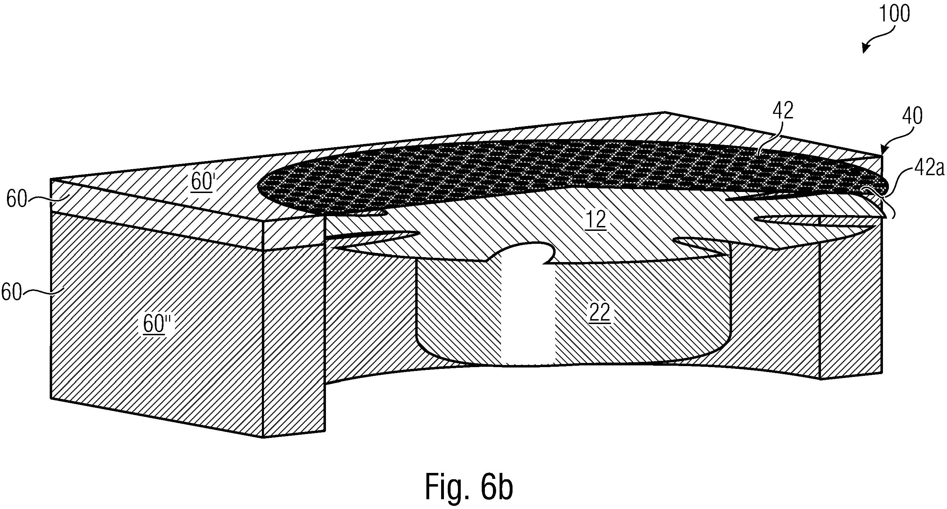

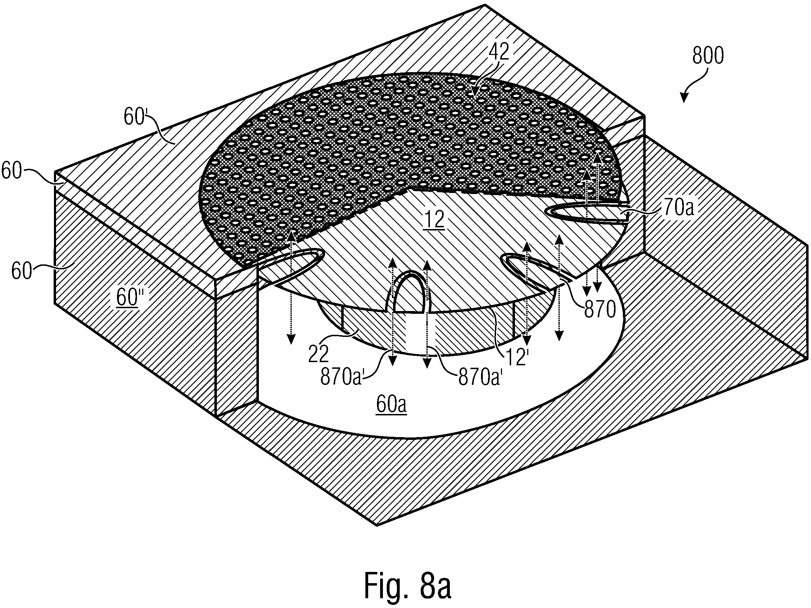

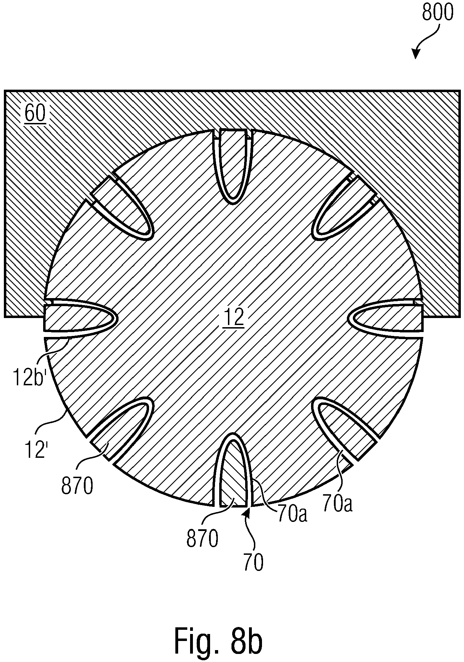

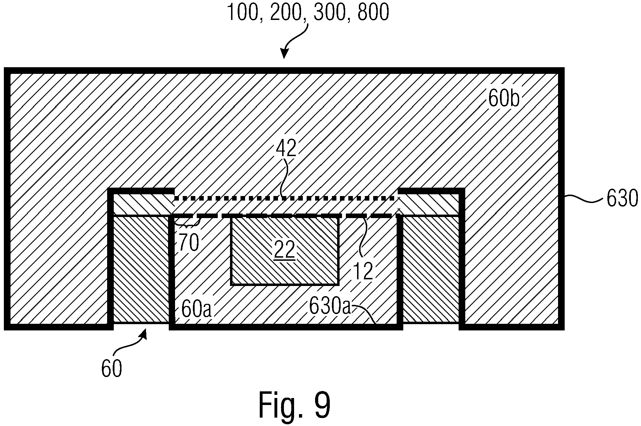

The supporting structure 60 may form a chamber 60a (cavity volume), e.g. closed by the membrane 12 (it is noted that the chamber 60a may be a closed volume with a floor 630a which is not shown in the figures apart from Fig. 9). Even if not shown in Figs. 1a and 1b, the supporting structure 60 may include a first block 60" and a cover 60' (see also below, in particular in Figs 6a, 6b, 8a, and 8b). As shown in Fig. 1a, the membrane 12 may have a first (internal) side 12i and a second (external) side 12e which are opposite with each other along the protrusion direction. The second (external) side 12e may be the side onto which the pressure to be measured is exerted, or in any case which is more exposed to an external environment. The first (internal) side 12i of the membrane 12 is the side from which the at least one mass element 22 is attached (e.g., suspended, fixed or integral thereto). The at least one mass element 22 may be, for example, in semiconductive material (e.g., silicone or a compound of silicone, such as polysilicon) or in metal material. The membrane 12 may be in a single layer or in a plurality of layers, stapled one on another. The membrane 12 may have a conductive layer (e.g., for obtaining the capacitor, see below) or may be in doped semiconductor material. The membrane 12 may have a disc shape, for example (e.g. a cylinder with diameter much greater than the height, which is the thickness of the disc) (but other shapes are possible). The membrane 12 may, in some examples, be planar, without corrugations.

The deformable membrane 12 may have a membrane border 12'. The membrane 12 may be clamped (or more in general attached, supported, etc.) in correspondence of the membrane border 12' (or at least in correspondence of some portions 12a" of the membrane border 12', see below). The deformable membrane 12 may be cantilevered to the structure 60. The deformable membrane 12 may be clamped to the support structure 60. The deformable membrane 12 may be held by the support structure 60. The membrane 12 may be secured to the support structure 60. The support structure 60 may operate as a holder. The membrane 12 may be at least partially inserted in the support structure 60, e.g. sandwiched between a cover 60' and a first part (first block) 60" (this is not shown in Figs. 1a-3, but is shown in Figs. 6a, 6b, 8a, 8b, etc.). The membrane 12 may be in polysilicon, or more in general a silicon based material (doped or non-doped, or with metal traces to make a conductor o a capacitor, see below).

The supporting connection between the membrane 12 and the support structure 60 may be (or more in general include) an elastic supporting connection. The membrane 12 may be cantilevered to the support structure 60. In the case of Figs. 1a and 1b, elasticity to the elastic supporting connection is achieved by reducing the contact between the border 12' of the membrane 12 and the support structure 60. This is obtained, in the example of Figs. 1a and 1b, by generating at least one aperture 70 (e.g. a plurality of apertures 70) in the membrane 12 so that at least part of the membrane border 12' is, in some portions, not in contact with the supporting structure 60. In Fig. 1b, a closed line (e.g. circumference) 12c is shown, which is not in completely coincident with the membrane border 12'. Some arches 12a" of the closed line (e.g. circumference) 12c actually coincide with portions of the membrane border 12', but other arches 12a' (alternated to the arches 12a") do not coincide with the membrane border 12'. This because of the presence of the aperture(s) 70, and the fact that the membrane border 12' is not completely in contact with the support structure 60. More in general, the membrane 12 may be partially separated (along some portions of its border 12') from the support structure 60, so that at least one aperture 70 is defined between the membrane 12 and the support structure 60. An interspace (aperture 70) is therefore obtained between the membrane 12 and the support structure 60.

The membrane border 12' (which may extend along the planar directions) can be understood as including:

- at least one contacting membrane border portion 12a" which contacts (e.g. is inserted in, and/or held by, and/or connected to, and/or clamped to) the supporting structure 60 (and which may coincide with the closed line 12c, which may be a circumference); and
- at least one free membrane border portion 12b' which does not contact (e.g. which is not inserted in, and/or not held by, and/or not connected to) the supporting structure 60 (and which may not coincide with the closed line 12c delimiting the internal extension of the supporting structure 60).

The free membrane border portions 12b' may be alternated to the contacting membrane border portion 12a", e.g. periodically. The circumferential arches 12a' in Fig. 1b are not part of the membrane border 12'. The free membrane border portions 12b' may be partially oval (partially elliptical), for example, or more in general curve. The free membrane border portions 12b' may be angularly alternated to the contacting membrane border portion 12a", e.g. according to a regular angular succession.

More in particular in the example of Figs. 1a and 1b, each contacting membrane border portion 12a" is a circumferential arch of the circumference 12c. In Fig. 1b each contacting membrane border portion 12a" is a circumferential arch of the circumference 12c; and at least one free membrane border portion 12b' is arcuate (and more in particular an elliptical arch) which does not contact the supporting structure 60, but which delimits the respective aperture 70.

By virtue of the presence of the aperture(s) 70, fluid communication is achieved. This permits, for example, an effective thermal exchange (ventilation) between the environments separated by the membrane 12. In general, it is preferable to have between 2 to 36 apertures. Each free membrane border portion 12b' (and each aperture 70) may have a summity 12b" (directed towards the central position of the membrane 12) which is arcuate, and/or may be convex (the membrane 12 being therefore concave, when see along the planar directions). Each free membrane border portion 12b' (and each aperture 70) may have at least two intersections 12b''' (vertexes) with the contacting membrane border portion(s) 12a' (which may be a sharp vertex, such as a cuspidal intersection). The arcuate (curved) shape of the summity 12b" of each aperture(s) 70 permits to increase elasticity and reduce stiffness, and to increase robustness. The fact that the vertexes 12b''' are sharp in the outer part of the aperture(s) (and of the membrane 12) is less stringent, because of the geometry of the membrane 12 and the structure 60. In particular, the at least one vertex 12b''' is less structurally solicited than the summity 12b", and can therefore be non-arcuate.

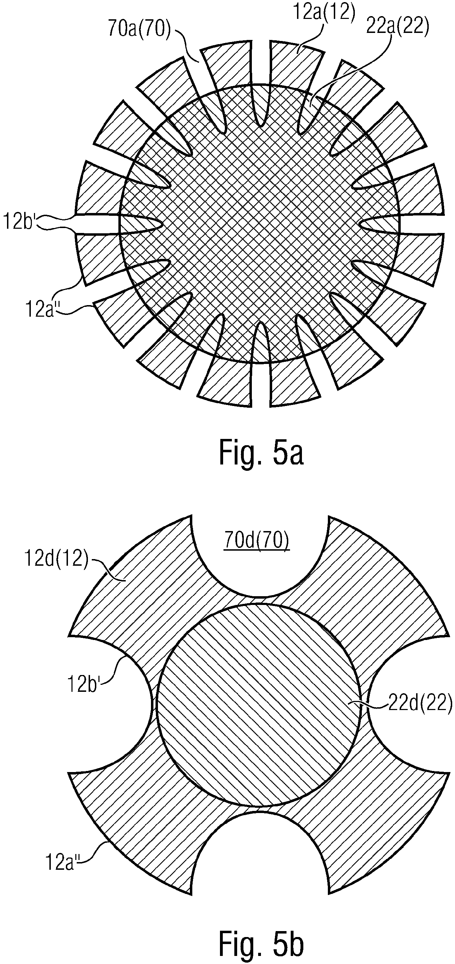

In examples, multiple apertures 70 may be present at regular intervals (e.g. at periodical angular intervals). For example, in Fig. 1b shows that the apertures 70 may be regularly angularly periodic (the angle vertexes being in the center of the membrane 12). E.g., in Fig. 1b the angular period is 45° (angle between two consecutive apertures 70), but different periodicities may be defined (they can be appreciated in Figs. 5a-5b, see below). It is in some examples preferable that the membrane 12 has a symmetry (e.g. radial symmetry, axial symmetry, or both), which also requires the apertures 70 to be equal to each other and be placed at symmetrical positions (e.g. radially symmetrical positions, axially symmetrical positions, or both), so as to have the center of mass of the membrane 12 in central position in the membrane 12. In general terms, the at least one mass element may have the center of mass centered with the center of the membrane. (In the examples in which there are multiple mass elements for the membrane, the center of mass of the complexive group of mass elements may be in the center of the membrane).

Fig. 1b shows the at least one aperture 70 to have an arcuate shape. The shape of each aperture 70 may be the geometrical intersection between:

the internal surface of a plan figure (e.g. a circle) contained in the border 12c (e.g. circumference); and an ellipse (whose border is partially coincident with the free membrane border portion 12b') having the major axis (i.e. the axis passing through the foci of the ellipse) directed towards the center of the circle encircled by the circumference 12').

It has been understood that the angular period of the apertures 70 (e.g. in combination with the radial directions of their major axes and/or of the radial symmetry and/or axial symmetry of the apertures 70) also permits to increase elasticity and decrease stiffness, in particular by virtue of the arcuate shape of the free membrane border portion 12b', in particular in proximity to the at least one mass element 22. Also the fact that the shape of the aperture(s) 70 are convex (causing the membrane 12 to have a concave shape when seen in the planar directions) permits to increase elasticity and reduce stiffness.

In examples above and below, the at least membrane is mostly represented as smooth elements, which surfaces (e.g., 12i, 12e in Fig. 1a) which are planar. However, corrugations may be present in some examples. Corrugations may be, for example, concentric. Corrugations may be circumferential. Corrugations may be centered in the center of the membrane. Any of the examples below may include corrugations, to further increase elasticity, e.g. placed between the aperture(s) 70 and the at least one mass element 22. It is noted that, without the elastic connection (e.g. provided by the apertures 70), the effect of the corrugations would be too unreliable.

The semiconductor device 100 may comprise a capacitor 40 with variable capacitance, and the membrane 12 may be one first electrode of the electrodes of the capacitor. The other electrode of the capacitor may be a backplate 42, which may be placed in more external position than the position of the membrane (e.g. external to the chamber 60a, and/or facing the external side 12e of the membrane 12). The backplate 42 may have passing holes that permit fluid communication therethrough (e.g. so as the membrane 12 can experience the pressure of the external environment).

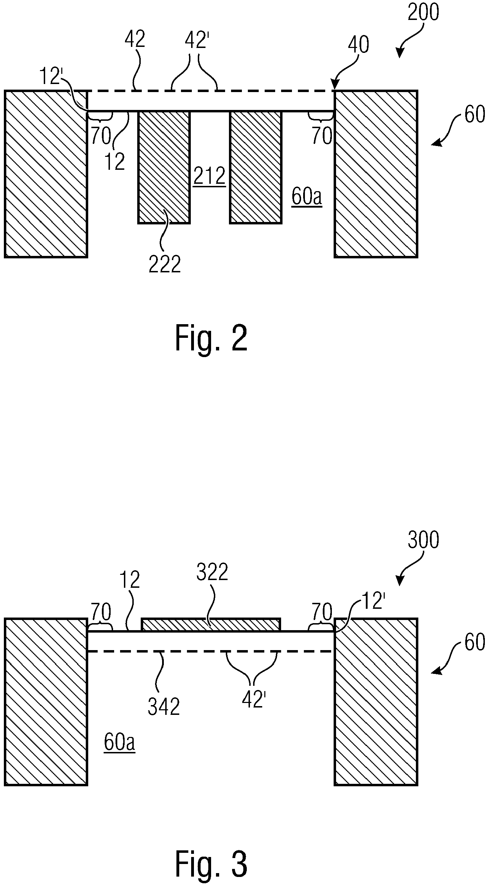

Fig. 2 shows a variant 200 of the example 100 of Figs. 1a and 1b. Here, the only difference is that the single mass element 222 has a central hole 212 (while the mass element 22 of Figs. 1a and 1b is a massive element, without holes). The hole 212 can be a through hole, but it does not need to be. The volume of the hole 212 is mainly determined by the inertial mass that the mass element 222 shall have. The center of mass of the complexive system formed by the membrane 12 and the single mass element 222 is in in central position. The at least one mass element 222 may be, for example, in semiconductive material (e.g., silicone or a compound of silicone, such as polysilicon). The hole 212 may be obtained by etching (e.g., by Bosch etching). However, like the example in Figs. 1a and 1b, the membrane 12 is connected to the structure 60 through the same elastic connection partially separated (in particular through apertures 70, which reduce the amount of elongation of the contacting membrane border portion(s) 12a" in contact with the supporting structure 60). It is to be noted that, despite etching (and in particular Bosch etching) being not necessarily a particularly precise technique (at least for the precision that the at least one mass element 222 shall have), the problem is diminished in view of the fact that the presence of the hole permits to increase the diameter of the at least one mass element 222, thereby reducing the precision issues (at small radii, precision becomes much more difficult to achieve). Even without increasing the radius, advantages are notwithstanding achieved in the process of manufacturing: the hole 222 permits to counteract mass radius deviations from wafer center to wafer edge by adjusting the hole radius properly from wafer center to wafer edge through mask layout. Therefore, the hole 212 permits to greatly increase precision of fabrication without too great effort.

Fig. 3 shows a variant 300 of the example of Figs. 1a and 1b. Here, the at least one mass element 322 (in the specific case, a single mass element) is in metal material. Preferred metal materials are Cu, Al, W, TiW, but other metal materials may be used in some examples). Notably, the extension, along the protrusion direction (vertical in Fig. 3), of the at least one mass element 322 in metal material is reduced with respect to the examples in Figs. 1a-2, because the metal has larger density than semiconductors. Moreover, the membrane 12 is external (the second electrode, backplate 342, which may also have through holes, is internal to the chamber 60 delimited by the structure 60 and the membrane 12). This is an advantage in the constructive method, since it is not necessary to perform Deep Reactive Ion Etching (DRIE) etching (which is a technique which often does not suite with the precision required for shaping the at least one mass element), and it is possible to use metal plating (e.g. electroplating) and/to electrodeposition, which are more precise techniques than etching. Like the examples of Figs. 1a-2, the membrane 12 is connected to the structure 60 through the same elastic connection partially separated (in particular through apertures 70, which reduce the amount of elongation of the contacting membrane border portion(s) 12" in contact with the supporting structure 60). It is by virtue of the elasticity of the connection between the membrane 12 and the support structure 60 that it is possible to use metal material for the at least one mass element 322, which otherwise could not be used, because a too thick metal layer would be required, and this would not be feasible with the current techniques. The thickness of the at least one mass element 322 in metal material may be, for example, with the present technique, less than 100 $\mu$m (micrometers). The thickness of the at least one mass element 322 in metal material may be, for example, or more preferably less than 50 $\mu$m (micrometers), or even more preferably between 1.5 $\mu$m (micrometers) and 30 $\mu$m (micrometers), and even more preferably between 1.5 $\mu$m (micrometers) and 20 $\mu$m (micrometers). Even if Fig. 3 shows that the metal layer 322 is directed externally and that the second electrode 42 is more internal than the membrane 12, in examples one or both of these two features may lack. The metal layer may be used for example in an example link in Fig. 1a (but the metal mass element would simply have smaller elongation in the protrusion direction).

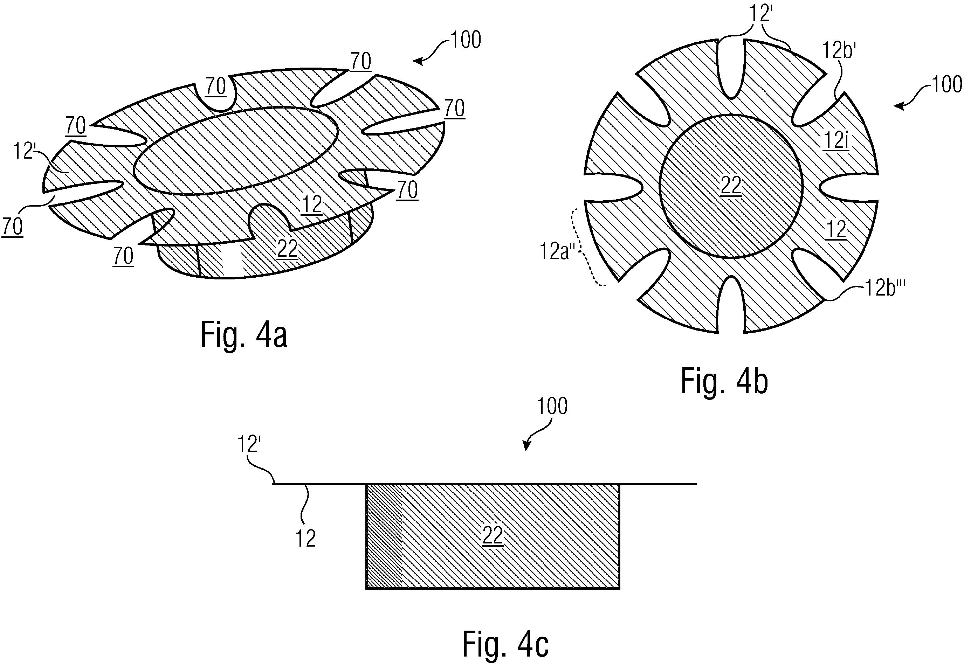

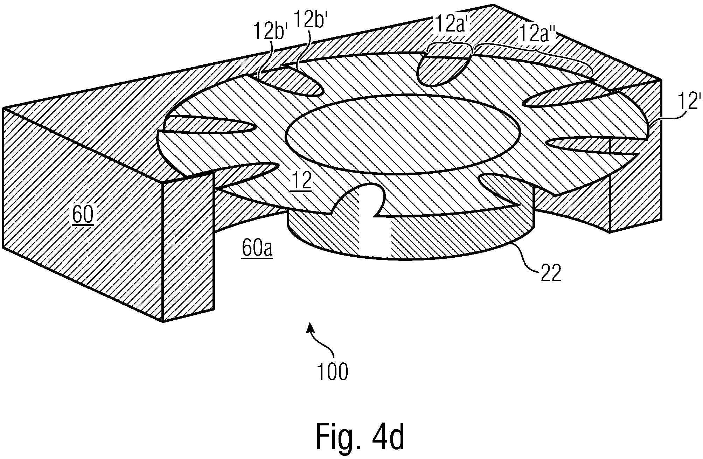

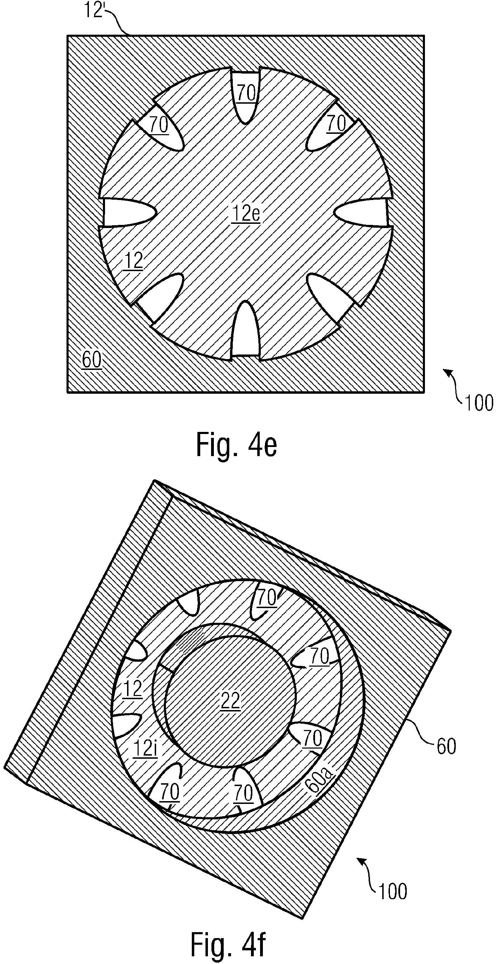

Figs. 4a-4f show particulars of elements of examples above and below. Reference numerals for clarity are those of Figs. 1a and 1b, but they may also be applied to the corresponding elements of the examples of Figs. 2 and 3. Fig. 4a shows a view in perspective of the membrane 12 and the at least one mass element 22 (or 222 or 322). Fig. 4b shows a view along two planar directions of the membrane 12 and the at least one mass element 22 (or 222 or 322) from below (i.e. from the internal chamber 60a). Fig. 4c shows a view along the protrusion direction (represented as vertical) and one planar direction of the membrane 12 and the at least one mass element 22 (or 222 or 322). Fig. 4d shows a view in perspective, and partially cross-sectioned, of the membrane 12 (represented completely) and the at least one mass element 22 (or 222 or 322) (represented in cross section). Fig. 4e shows a view along two planar directions of the membrane 12 and the at least one mass element 22 (or 222 or 322) from above (i.e. from outside the internal chamber 60a). Fig. 4f shows a view in perspective of the membrane 12 and the at least one mass element 22 (or 222 or 322).

Figs. 5a-5b also show examples of configurations of the membrane 12 (12a and 12d, respectively) and the at least one mass element 22 (22a and 22d, respectively) (in these cases, only one single mass element is present). As can be seen from Fig. 5a, another advantage of the present examples is that it is possible to make the at least one mass element 22a to partially cover the aperture(s) 70 (70a) of Figs. 1a and 2. Therefore, the at least one mass element (22a) may protrude from the membrane 12 along at least one of the planar directions and partially overlap with the aperture(s) 70 (70a). This also increases the stockiness maintaining the elasticity provided by the apertures 70 (70a). Basically, in Fig. 5a, the ratio between the planar extension of the mass element (22a) and the planar extension of the membrane (12a) is increased with respect to that in the prior art, thereby increasing stockiness. In Fig. 5b the mass element 22d does not cover the apertures 70d. The example of Fig. 5b is more adapted to the mass element 322 in metal material, while the example of Fig. 5a is often better adapted for the semiconductor material. Any of the examples of Figs. 5a-5b may also have a hole in the mass element (22a or 22d), e.g. as shown in Fig. 2, or more in general a through hole or a non-through hole.

Figs. 8a and 8b show another variant in which the at least one aperture 70 is partially occupied by a flap 870 attached to (and/or fixed to, and/or held by, and/or integral in one piece with) the structure 60. The shape of each flap 870 may be similar to the shape of the shape of the aperture 70 which the flap 870 partially occupies, but in a reduced scale. The presence of the flap (only partially obstructing the fluid communication permitted by the aperture 70) reduces the volumetric flow of fluid through the at least one aperture 70. The at least one aperture 70 still permits the fluid communication through a slit 70a formed between a the flap 870 and the membrane 12. Basically, each flap 870 has a border which faces the free membrane border portion 12b' of the particular aperture 70. The at least one flap 870 does not participate to the vibration of the membrane 12, since it is detached from the membrane 12 (and is fixed to the structure 60). However, the fluid communication through the at least one aperture 70 is notwithstanding guaranteed, as indicated by the arrows 870a' in Fig. 8a (through the slits 70a). This solution permits an adequate fluidic mass exchange through the slits 70a, without exaggerating, and also permits to maintain the elasticity required. The flap(s) 870 control the fluidic damping through the aperture(s) 70 (in particular through the slit(s) 70a) and adjust the stiffening effect of the chamber 60a. This permits to reduce the Q-factor of the fundamental mode of the vibration and the total noise to result, thereby reducing disturbance for the frequency response. It is also noted that the slit(s) 70a may also be made by removing (e.g. by etching) portions of the membrane 12, therefore simplifying the manufacturing process.

Fig. 9 shows a broader view of the semiconductor device 100, 200, 300, 800 (or those in Figs. 5a-5b, or some which are below). Here, it is shown that the supporting structure 60 is fixed to an external structure 630 (which may be, for example, represented as a box, and may be a chip, or be contained in a chip). The external structure 630 may define a closed environment 60b (fluidic backvolume). A floor 630a of the chamber 60a may therefore be obtained through the external structure 630. The supporting structure 60, the membrane 12, the backplate 42 (if present), and the mass 22 (or 322) may be enclosed in the closed environment 60b. In some examples (e.g., those in which the pressure of the external environment is to be measured) some through holes (not shown in Fig. 9) may be present.

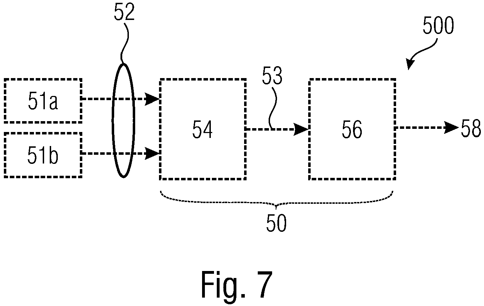

The semiconductor device 100, 200, 300, 800 (in any variant, e.g. those shown in Figs. 5a-5b, etc., or any of those disclosed below) may include at least one electric conductor (e.g. two conductors 51a, 51b, see Fig. 7), to acquire an electric signal 52 indicative of the deformation (e.g. displacement) of the membrane 12. In general terms, the at least one conductor may be applied to the membrane 12. A second conductor may be applied (in case of capacitor) to the second electrode 42, for example. For example, vias, traces and/or other electric connections may be used.

The semiconductor device 100, 200, 300 (or any one shown in figs. 5a-5b etc.) may operate as (or being part of) a vibration sensor or acceleration sensor, or pressure sensor (see sensor device 500 in Fig. 7, for example). The semiconductor device 100, 200, 300, 800 (e.g. those shown in Figs. etc. or any of those disclosed below) may obtain a particular electric signal 52 associated with the experienced vibration (or acceleration or pressure) in a particular range characteristic of the deformable membrane (the electric signal 52, or a processed version thereof, will then be read out, e.g. by a measurer, e.g. downstream to an analog-to-digital circuitry 54).

The sensor device 500 of Fig. 7 may be, or be part of, a voice pickup unit (VPU). The semiconductor device 100, 200, 300, 800, 1000, 1100, 1200, etc. may include circuitry 50 which may, for example, be implement application-specific integrated circuit (ASIC), or another micro-processor based system or another circuitry. The circuitry 50 may include at least one of:

- analog-to-digital circuitry 54 to convert the electric signal 52 indicative of the deformation of the deformable membrane 12, 312, 678, etc. onto a digital version 53; and

- at least one digital measurer 56 to obtain, from the digital version 53 of the electric signal 52, a measurement 58 of at least one pressure, vibration, and acceleration.

The sensor device 500 may include a plurality of semiconductor devices (e.g. as above, 100, 200, 300, 800, etc., or below, e.g. 1000, 1100, 1200, etc. ) with different displacements, weights, shapes, of the mass elements (e.g., each of them being particularly sensitive to a particular acceleration range, vibration range, or pressure range). Accordingly, a plurality of different electric signals 52 may be acquired simultaneously, and the acceleration, vibration, or pressure can be measured with increased precision through signal processing involving the different electric signals 52 obtained simultaneously. The electric signals 52 may be inputted to the analog-to-digital converter 54, which may provide the digital version 53 of the signals 52. Signal processing may be performed by the digital measurer 56 on the digital versions 53 of the electric signals 52, for example. In some cases, a semiconductor device without mass element may be used (e.g., a conventional microphone or other vibration sensor) in combination with at least one or more semiconductor device(s) 100, 200, 300, 800, 1000, 1100, 1200, etc. Also in that case, the digital signal obtained by the conventional microphone or other vibration sensor may be used to obtain the pursued measurement 58 of the acceleration, vibration, pressure, through signal processing (e.g. performed by the digital measurer 56) in combination with the electric signal(s) 52 obtained by the at least one or more semiconductor device(s) (e.g. 100, 200, 300, 800, 1000, 1100, 1200, etc.).

The semiconductor device (e.g. 100, 200, 300, 800, 1000, 1100, 1200, etc.) may be associated, e.g. in the same structure (e.g. in the same chip) with a multiplicity of other semiconductor devices, each having at least one deformable membrane (which may be similar to the membrane 12), and all the semiconductor devices can operate synchronously, e.g. by sensing a vibration, an acceleration, or a pressure, simultaneously (e.g., in such a way that different semiconductor devices are sensitive to different ranges of acceleration, vibration, pressure). Different membranes of different semiconductor devices in the same structure (e.g. same chip) may have the same shape, or different shapes. Different membranes of different semiconductor devices in the same structure (e.g. same chip) may have different numbers of mass elements, or the same number of mass elements. Different membranes of different semiconductor devices in the same structure 60 (e.g. same chip) may be simultaneously subjected to different displacements even when the sensor 500 is experiencing the same vibration (or acceleration or pressure). Therefore, each different semiconductor device among the multiplicity of semiconductor devices in the same sensor device may be susceptible to (or particularly sensitive to) a different ranges of vibration, acceleration or pressure. It is also possible that the same sensor device that hosts the semiconductor device 100, 200, 300, 800, 1000, 1100, 1200 (e.g. those shown in Figs. 5a-5b, etc.) also comprises different semiconductor device(s) (e.g. at least one microphone or another semiconductor device which is not like the semiconductor device 100, 200, 300, e.g. those shown in Figs. 5a-5f, etc.; for example, it may lack a mass element, operating such as a traditional microphone). The semiconductor device 100, 200, 300, 800, 1000, 1100, 1200, etc. (or the sensor device comprising the semiconductor device) may be used, in particular, for a voice pickup unit (VPU) for picking up vibration signals from bone during speech (which may be an example of the sensor device). The semiconductor device may be used for sensing inertial forces.

In the examples above the semiconductor device 100, 200, 300, 800 (e.g. those shown in Figs. 5a-5b, 6a, 6b, 8a, 8b, etc.) often comprises a capacitor 40 with variable capacitance.

A three-dimensional example is provide in Figs. 6a and 6b. The semiconductor device may be of the single backplate type (the backplate embodying the second electrode 42), but in some examples it may have multiple backplates (e.g. the membrane 12 being interposed between the two backplates). The capacitor 40 has at least one first electrode (which is, or is part of, or comprises the deformable membrane 12) and at least one second electrode 42 (which in this case is fixed and/or non-displaceable, since it does not deform with vibration, acceleration or pressure), which are separated through a gap 42a (Fig. 6b). The deformable membrane 12 may be in conductive material, or may have at least one conductive layer (e.g. metal or highly-doped semiconductor material). The capacitor 40 formed by the deformable membrane 12 and the second electrode 42 therefore has a dielectric gap 42a therebetween. The gap 42a is modified in consequence of the deformation (e.g. displacement) of the membrane 12. Hence, the gap 42a results associated with the vibration, acceleration, or pressure to which the deformable membrane 12 is subjected. The modification of the dielectric gap 42a (change of the distance between the deformable membrane 12 and the second electrode 42) accordingly causes a variation of the capacitance of the capacitor 40. The electric signal 52 is therefore subjected to the instantaneous variation of the capacitance of the capacitor 40 and, therefore, also provides information on the vibration, acceleration, or pressure to which the deformable membrane 12 is instantaneously subjected. The electric signal 52 is therefore indicative of the pressure, acceleration, or vibration acting on the deformable membrane 12. In particular when operating for sensing a pressure, the second electrode 42 may have at last one through hole (e.g. a plurality of holes or perforations 42', such as a matrix of holes like in Fig. 2), e.g. to permit the pressure (e.g. sound) to arrive at least at the second side 12b of the deformable membrane 12 (as shown in Fig. 3, also in the case in which the second electrode 42 is more internal than the deformable membrane 12 there may be made at least one hole 42', more probably a plurality of holes 42', or perforations). It is intended that the second electrode 42 may be (or at least have a layer) made of conductor material (e.g., metal) or highly doped semiconductor material. Fig. 6a shows a cover 60' which is part of the support structure 60 (in the examples of Figs. 1 and 3 the cover 60' is not shown, but may be notwithstanding present). The cover 60' may, in some examples, sandwich the membrane border 12' (and in particular the at least one contacting membrane border portion 12a") onto a first part (first block) 60" of the support structure 60.

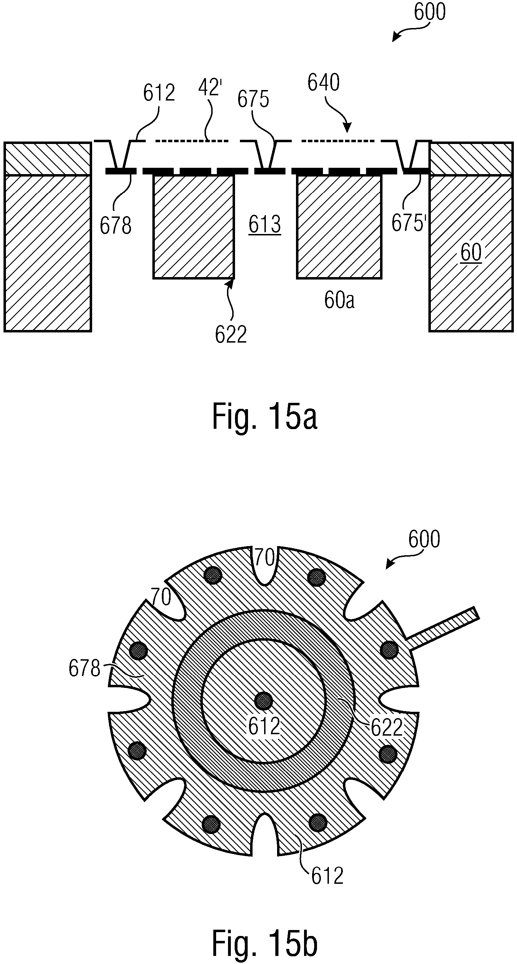

With reference to Figs. 15a and 15b, in another example there are provided the deformable membrane 678 and a backplate 612 (which may be an example of the second electrode 42). The backplate 612 is stiff, while the membrane 678 is deformable. The deformable membrane 678 (which substantially plays the role of the deformable membrane in the examples above, e.g. the membrane 12 in Figs. 1a and 1b) and the backplate 612 (which may play the role of the second electrode 42) may form, for example, a capacitor 640 (example of the capacitor 40). At least one support post 675 (e.g. in a position corresponding to the central position of the membrane 678) may permit the backplate 612 to keep in position the membrane 678, e.g. by contact and/or by mechanical connection. Further support posts may be in lateral positions (e.g., to fix the membrane 678 to the structure 60). The support post(s) may be in dielectric material or non-doped semiconductive material, so as to avoid electric contacts between the membrane 678 and the backplate 612. The backplate 612 may be supported by (e.g. clamped by) the structure 60 (e.g. through support post(s)). The membrane 678 (which supports, attached thereto or integral therewith, the at least one mass element 622) may be like the membrane 12 as any of the examples above, and may be, for example, elastically supported by the structure 60. The membrane 678 may substantially be floating. The membrane 678 may be fixed to the structure 60 e.g. through at least one beam 675' (e.g., in the peripheral position of the membrane, e.g. also connected to a support post of the backplate 612, which in turn is mechanically connected to the structure). The backplate 612 may have through holes (perforations) 42' (like in Figs. 1a, 1b, 6a, 6b, 8a, and 9). Due to the presence of the at least one support post 675 in central position, the membrane 678 may deform in a donut-like fashion. The at least one mass element 622 may also have a hole (which may be a though hole) 613 in central position. The hole 613 of the at least one mass element 622 (in particular when there is only one single mass element 622, or at least when there is one mass element in central position of the membrane 678) may be in correspondence of the at least one central support post 675. All the examples above (including the material of the mass element 622 in metal or in semiconductor material, the thickness, the shape of the first membrane 678, the possibility of being inserted in the external structure 630, etc.) may also be present in the example of Figs. 15a and 15b. In these examples, the membrane 678 has still an elastic connection with the structure 60. In this case, the aperture(s) 70 may be present or not present. The border of the membrane 678 can be (but in some example is not necessarily) in contact with the structure 60.

The present examples may also be applied to the case in which the semiconductor device 100, 200, 300, 800 (e.g. one of the variants shown in Figs. 5a-5b, etc.) does not include the capacitor 40 (and the second electrode 42), but, still, the electric signal 52 provides information on the vibration, acceleration, pressure. For example, if the semiconductor device 100, 200, 300, 800 (e.g. those shown in Figs. 5a-5b, etc.) is of the piezoelectric type, then the membrane includes a piezoelectric membrane in a piezoelectric material, and is electrically connected to the electric conductors 51a, 51b. The piezoelectric membrane causes the variation of the electrical signal 52. The electric conductors may be, in that case, applied to in different sides (e.g. counter posed with each other) of the piezoelectric membrane: for example, the conductor 51a could be connected to the second, external side 12e, and conductor 51b could be connected to the first, internal side 12i of the piezoelectric membrane. In the case of piezoelectric membrane, then the element 42 of Figs. 1a and 2 and the element 342 of Fig. 3 is not present. Some examples are provided here below.

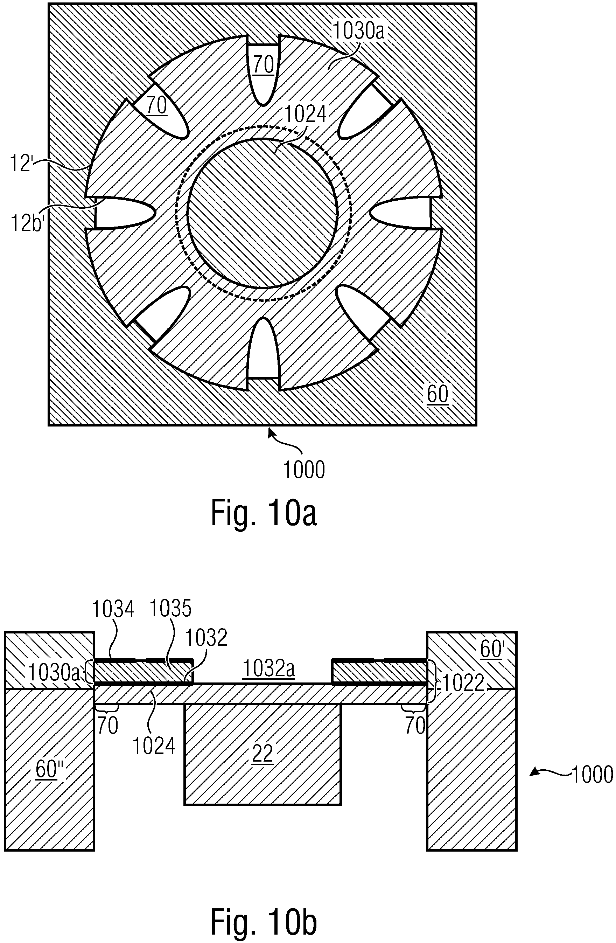

Figs. 10a and 10b show a different example 1000 in which, instead of implementing the capacitor 40, a piezoelectric technique is used. As can be seen from Figs. 10a and 10b, the deformable membrane is a piezoelectric membrane 1022. The piezoelectric membrane 1022 may be cantilevered to the structure 60. At least one mass element 22 is attached to (e.g. clamped to) the membrane 1022. The membrane 1022 is provided with the at least one supporting connection which includes the at least one elastic supporting connection. Also in this case, the elastic supporting connection is obtained by partially separating the support structure 60 from the membrane 12 (e.g. using the aperture 70, which partially separates some portions 12b' of the membrane border 12' of the membrane, thereby increasing the elasticity to reduce stiffness). Basically, all the discussion above for the previous examples may be maintained (including the geometrical properties of the membrane and the apertures), even though instead of the elements of the capacitive technique, there is implemented a piezoelectric technique. As can be seen from Figs. 10a and 10b, the membrane 1022 may include at least one piezoelectric layer 1030a. In this case, the at least one piezoelectric layer 1030a includes an elastic sublayer 1035 and at least one piezoelectric sublayer 1032, 1034. The two piezoelectric sublayers 1032 and 1034 are separated from each other by the sublayer 1035, which may be a non-piezoelectric layer, but is a deformable layer. A central hole (e.g. through hole) 1032a may be present in the center position of the piezoelectric sublayer 1030a (e.g. corresponding to the position of the mass element 22). A support layer 1024 (in deformable material) may also be present and stapled to the piezoelectric sublayer 1030a. The piezoelectric sublayer 1038 can be sustained by the support layer 1024. The at least one mass element 1022 may be in contact (e.g., integral) with the support layer 1024. The vibration, under the influence of the inertia of the at least one mass element 1022, deforms both the support membrane 1024 and the piezoelectric membrane 1030a (including the sublayers 1032, 1034, 1035) so as to cause the insurgence of the piezoelectric effect in piezoelectric sublayers 1032 and 1034, so that the electric signal 52 is acquired.

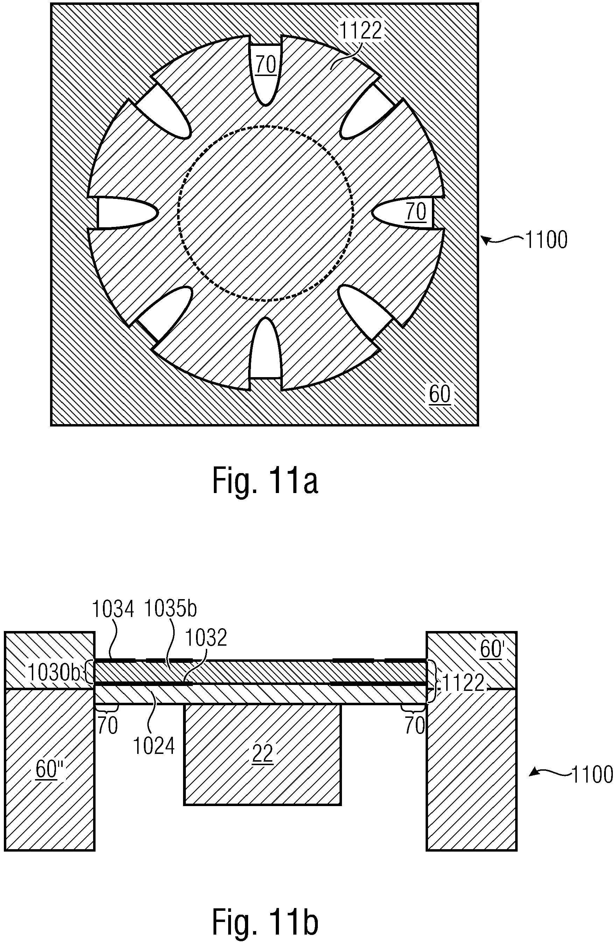

Figs. 11a and 11b show another example 1100. In this example, the membrane 1122 may include, together with the support layer 1024, also a piezoelectric sublayer 1030b which lacks of the central hole 1032a of Figs. 10a and 10b (for the rest, it is the same example). It is to be noted, notwithstanding, that both the layers 1024 and 1030b comprise the apertures 70 in the same way as described for the device 1000 discussed above. In this case, similarly to the example 1000, also the piezoelectric layer 1030b comprises at least one (preferable two) piezoelectric sublayers 1032, 1034 separated by each other through 1035b.

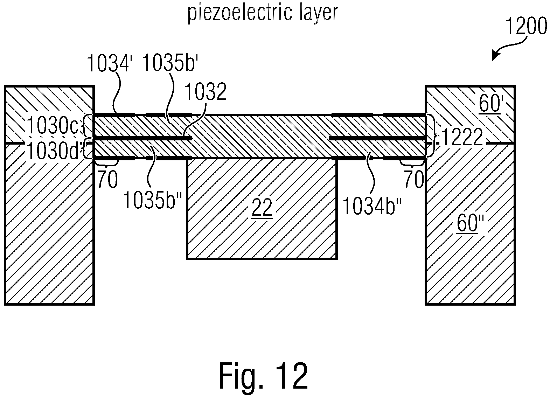

Another example 1200 is shown in Fig. 12. In this case, the support layer 1024 is not present (but it can be present in some examples). The membrane 1222 here comprises one single piezoelectric layer which is separated between at least two piezoelectric sublayers 1030c and 1030d each stapled one over the other. The first piezoelectric layer 1030c may include at least one (preferably two) piezoelectric sublayers 1034' and 1032 separated from each other by the non-piezoelectric sublayers 1035b' and 1035b". The second layer 1030d may include a first piezoelectric layer 1035b". The piezoelectric layer 1035b" may separate the sublayer 1034" from the sublayer 1032.

It is to be noted that the variants of Figs. 2, 3, 5a-5b, etc. are also valid for the piezoelectric versions, once the membrane 12 of 2, 3, 5a-5b is substituted by a piezoelectric membrane (e.g. 1022, 1122, 1222) and the second electrode 42 or 342 is not present.

In some cases, instead of using a capacitive technique or a piezoelectric technique, a piezoresistive technique may be used. For example, the electric signal 52 may be subjected to the resistance of the membrane 12 (which here operates as a resistor with variable resistance). The resistance of the membrane 12 varies with the deformation (e.g. if the shape of the membrane is more arcuate, then the resistance is increased, and, and, if the shape is more flat, then the resistance is decreased). In this case, the membrane, which is in piezoresistive material (e.g. doped semiconductor material) will be subjected to a measurement through the conductors 51a and 51b in different portions thereof (e.g., in two different portions of the membrane border 12'). The electrode 42 is in this case not necessary.

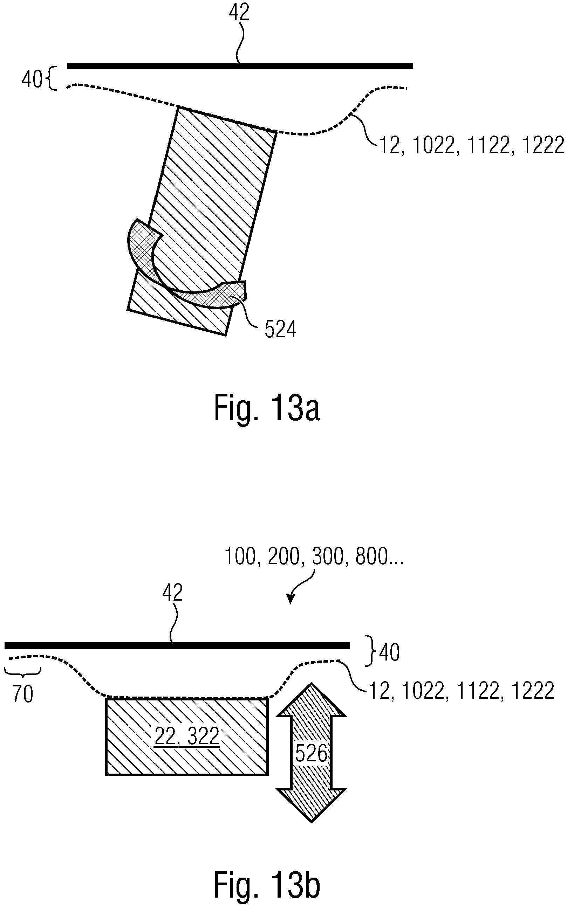

Reference can be now made to Fig. 13a (showing a conventional technique) and Fig. 13b (showing a technique proposed in the present document). The conventional technique requires the mass element to be very elongated in the protrusion direction (vertical in Figs. 13a and 13b), to increase inertia without increasing stiffness too much, but causing unwanted tilting modes 524. On the contrary, with the present technique (shown in Fig. 13a), in view of the elasticity obtained through the elastic supporting connection, it is possible to reduce the elongation of the at least mass element 22, 222, 322 (22a, 22d, etc.) in the protrusion direction and to increase the elongation(s) in the planar direction(s) (parallel to the extension of the membrane 12). Hence, the center of mass of the at least mass element 22, 322 is closer to the membrane 12, which facilitates reaching a piston mode 526 at lower frequencies than the tilting mode.

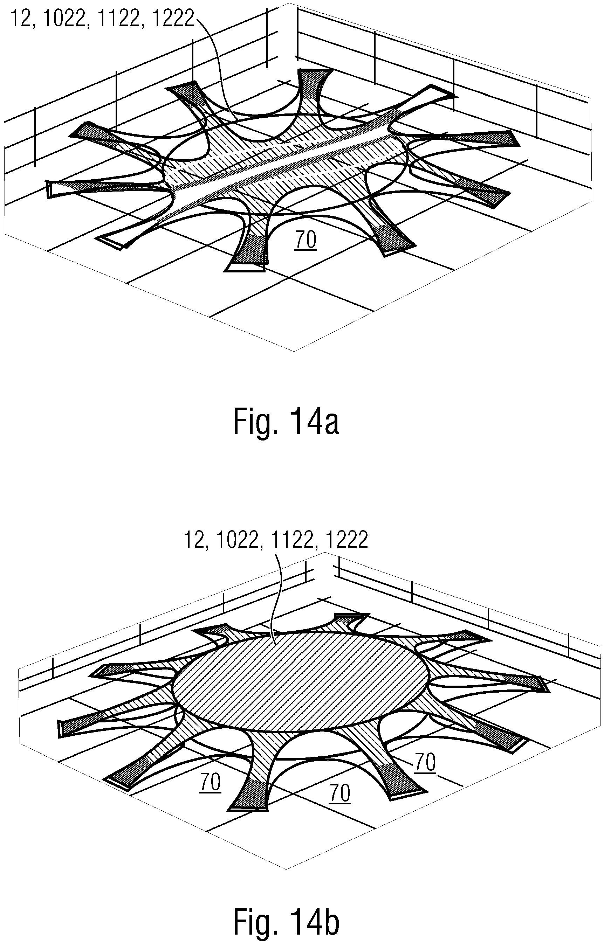

Figs. 14a and 14b show simulations on the claimed example. In this case, the position of the at least one mass element 22, 322 (which is not shown) is over the membrane (like in Fig. 3), but analogous results would be obtained with the other examples. In Fig. 14b there is simulated the membrane 12 moving according to the piston mode. Thanks to its elastic supporting connection, for its greater extension, the membrane 12 is deformed uniformly. On the other side, Fig. 14a shows the simulation of a tilting mode. Figs. 14a and 14b show the better mode separation due to the stockiness of the mass element, as achieved thanks to the present techniques. The piston mode (Fig. 14b) is around 6 kHz, whereas the tilting mode (Fig. 14b) occurs at much higher frequencies (around 12 kHz). In sharp contrast, in conventional technique (with a more elongated mass) the tilting mode would occur at a lower frequency. For example, in the conventional techniques the tilting mode would occur at a frequency closer to the frequencies at which the piston mode occurs, or even at a lower frequency in some cases.

Without exceeding in mathematical formalisms, in an oscillating system (such as a system formed by the at least one mass element 22, 222, 322, 22a, 22d, etc. and the membrane 12), the resonance frequency $f_r$ is

given by $f_r = \dfrac{1}{2 \cdot \pi} \cdot \sqrt{\dfrac{K}{m}}$ (or more in general by a relationship according to which $f_r$ is proportional to $\sqrt{\dfrac{K}{m}}$

), where $K$ is the effective elastic stiffness of the membrane 12, and $m$ is the effective mass of the at least one mass element (e.g. 22, 322, 22a, 22d, etc.) and the membrane 12. If the elastic stiffness $K$ is reduced (e.g., by virtue of the aperture(s) 70), then the resonance frequency $f_r$ is accordingly reduced. Further, also the mass $m$ of the at least one mass element may be accordingly reduced, since this is permitted by the reduction of the stiffness $K$. This permits, inter alia, to make the mass element in metal material, which was previously impracticable. On the other side, in order to reduce the frequency $f_r$, we don't need to increase the mass (but we can ever reduce it), because we can rely on the reduction of the stiffness $K$.

Notably, there is also the opportunity of using, for the mass element(s), heavy materials (e.g., metals) instead of silicon-based materials. By using metals it is possible to define a height (elongation in the protrusion direction) which is even less than 10 μm (micrometers). In this case, the use of metals is extremely advantageous (its thickness deposition capabilities is not high, and it is often below 50 μm, micrometers, or 30 μm, micrometers, or 20 μm, micrometers, according to particular application). The use of metals is preferably based on a structuring process like lifting-off. Even if etching may be used also for metals, it is easier and more accurate than e.g. Bosch etching semiconductor materials.

In many of the examples above it has been explained that, thanks to the increased elasticity of the supporting connection, the stockiness may be increased. However, advantages are also obtained even without changing the dimensions of the mass element(s). In fact, the increased elasticity permits notwithstanding to reduce stiffness, thereby reducing the risk of breakage, thereby increasing reliability.

In the present examples, the thickness of the at least one mass element 322, when implemented in metal, may be less than 100 μm (micrometers), e.g. thicker than 1.5 and/or less thick than 30 (e.g. between 5 and 15, or between 1.5 and 20) μm (micrometers). The thickness of the at least one mass element 22, 222, 22a, 22d, etc. when implemented in semiconductor material (e.g. silicon based material) may be less than 350 μm (micrometers), e.g. larger than 50 and/or less than 300 μm (micrometers). The thickness is in the protrusion direction: if the at least one mass element is a cylinder, the thickness is the height of the cylinder and is elongated along the protrusion direction (e.g., vertical in Fig. 1a) (while the circumference of the cylinder is along the planar directions). The thickness of the membrane (e.g. 12, 1022, 1122, 1222, 678) may be greater than 200 nm (micrometers) and/or less than 10 μm (micrometers), e.g. less than 5 μm (micrometers).

A height to radius ratio of the mass element may preferably be in the range from 0.1 to 1 for semiconductor materials and 0.005 to 0.25 for metals (the radius extending in planar direction, the height extending in the protrusion direction). In case of non-cylindrical mass element, the radius is the radius of the circle having the same area of the area of the surface of the mass element, with the possible use of shape factor associated to the shape of the surface of the mas element.

It is possible to make the semiconductor device 100, 200, 300, 800, 1000, 1100, 1200 (or any of those shown in Figs. 5a-5b, etc.) by implementing a method such as:

1) making:

- a support structure (e.g. 60) (or more in general the structure 630, such as the chip), and
- a deformable membrane (e.g. 12) supported by the support structure (e.g. 60) through at least one supporting connection,
- in such a way that the at least one supporting connection includes at least one elastic connection, the at least one mass element (e.g. 22, 222, 322, 22a, 22d) being attached to, or integral with, the deformable membrane (e.g. 12); and

2) electrically connecting the deformable membrane (e.g. 12) to a circuitry (e.g. 50), the circuitry being configured to acquire an electric signal (e.g. 52) indicative of the deformation of the membrane (e.g. 12, 1022, 1122, 1222) conditioned by the movement of the at least one mass element (e.g. 22, 222, 322, 22a, 22d, 1022, 1122, 1222 etc.).

In the cases in which the at least one mass element (e.g. 22, 222, 22a, 22d, 1022, 1122, 1222 etc.) is not in metal material, it is advantageous if the block portion (first block) 60" of the support structure 60 and the at least one mass element are made from the same block of silicon-based material (precursor of the block portion 60" and of the at least one mass element), e.g. Si substrate and/or polysilicon. Even though the at least one mass element and the block portion 60" are detached in the final product, they may advantageously be generated from one single block by removing the material which occupies the volume which is finally occupied by the chamber 60a.

It is advantageous if the membrane 12 is made by deposition (e.g., deposition of polysilicon) on the block portion 60" of the support structure 60 or on the precursor of the block portion 60" and of the at least one mass element.

It is advantageous if the cover 60' of the support structure 60 is made by depositing material (e.g. semiconductor material) on the block portion 60" of the support structure 60 or on the precursor of the block portion 60" and of the at least one mass element. The membrane 12 (and in particular the border 12', e.g. in correspondence of the 12b' contacting membrane border portions 12a") may therefore be sandwiched between the block portion 60" and the cover 60'.

It is advantageous if the membrane 12 is structured (e.g., by etching, such as plasma or wet etching), by removing material of the membrane 12 in correspondence of the aperture(s) 70 and/or of the slit(s) 70a. It is particularly advantageous to make the slits 70a (in case they are required) after the membrane is applied to the structure 60, because the flaps 870 (which are originally part of the membrane) are subsequently separated from the membrane, and end being part of the support structure 60.

It is advantageous if the structuring of the at least one mass element and/or the removing of material from the precursor of the block portion 60" and of the at least one mass element is performed after the membrane being deposited. The perforation of the mass element (e.g.,. to obtain the hole 222) may be also performed by etching in this step.

In the case of the at least one mass element (e.g. 322) being in metal material, it is possible to perform metal deposition, such as metal plating, e.g. electro plating, e.g. based on electrolysis. This is a much preferable technique than Bosch etching, because permits to achieve a greater precision. It is also possible to perform physical vapor deposition (PVD), e.g. performed in vacuum. PVD is also more precise than Bosch etching (e.g. obtain through passages of sputtering and evaporation). It is noted that even in the case of the at least one mass element being in metal material, an etching step may be in some examples performed, to define the lateral shape of the at least one mass element. However, the processes used for etching the metal material are more precise that Bosch etching.

In particular in the case in which the semiconductor device includes a capacitor (40) with variable capacitance, the method may include making the second electrode (42) before, and in a more internal position than, the membrane (12). The at least one mass element may therefore be made more external than the membrane. Layer growth may be used, which is a particularly precise technique. This technique permits to use layer growth (or other methods) for making the metal layer 322, in particular in external position like in Fig. 3.

Electric connections may be performed e.g., by making vias and/or traces (or other electric connections), for example, on the structure 60, and more in general by connecting the membrane (and, in case, also the second electrode 42) to circuitry 50 for processing the obtained signal 52.

The sensor 500 may be manufactured by connecting the electric connections to analog-to-digital circuitry 54, which has the role of converting the electric signal 52 indicative of the deformation of the membrane 12 onto a digital version 53. The output of the analog-to-digital circuitry 54 may be electrically connected to at least one digital measurer 56 to obtain, from the digital version 53 of the electric signal 52, the measurement 58 of at least one of pressure, vibration, and acceleration. In some cases, the circuitry 50 is integrated in one single structure (e.g., one chip), and therefore the analog-to-digital circuitry 54 and the at least one digital measurer 56 may be embodied by the same single structure.

**Claims**

1. A semiconductor device (100, 200, 300, 800, 1000, 1100, 1200) comprising:

    a deformable membrane (12);
    a support structure (60), the deformable membrane (12) being connected to the support structure (60) through at least one supporting connection, wherein the at least one supporting connection includes at least one elastic supporting connection;
    at least one electric contact (51a, 51b) to obtain an electric signal (52) indicative of the deformation of the deformable membrane (12); and
    at least one mass element (22, 22a, 22d) attached to, or integral with, the deformable membrane (12, 1022, 1122, 1222).

2. The semiconductor device of claim 1, wherein the deformable membrane (12) is:

    partially inserted in, or is partially integral with, the support structure (60), and
    partially separated from the support structure (60) so that at least one aperture (70) is defined by the deformable membrane (12) and the support structure (60).

3. The semiconductor device (100, 600) of claim 2, wherein at least one mass element (22, 22a, 22d) partially overlaps with at least one aperture (70).

4. The semiconductor device (100, 600) of claim 2 or 3, further comprising at least one flap (870) separated from the deformable membrane and supported by the support structure (60), each flap (870) partially occupying, or overlapping with, at least one aperture (70).

5. The semiconductor device of any of the preceding claims, comprising one single mass element (222) presenting a central hole (212).

6. The semiconductor device (100) of any of the preceding claims, wherein at least one mass element (22, 22a, 22d) is in metal material.

7. The semiconductor device (100) of any of the preceding claims,
   wherein at least one mass element has a thickness less than 300 μm (micrometers).

8. The semiconductor device of any of the preceding claims, wherein the at least one mass element (22, 22a, 22d, 222, 322) is subjected to a movement to generate, as a resultant, at least one translatorily oscillating mode.

9. The semiconductor device of any of the preceding claims, wherein the center of mass of the at least one mass element (22, 222, 322, 22a, 22d) is in centered position of the deformable membrane (12).

10. The semiconductor device (100, 600) of any of the preceding claims, comprising a capacitor (40, 640) with variable capacitance, the capacitor (40, 640) having at least one first electrode and at least one second electrode (42, 612), the at least one first electrode including the deformable membrane (12, 678), the capacitance being varied in consequence of the membrane's deformation conditioned by the movement of the at least one mass element (22, 322, 22a, 22d, 600), the electric signal (52) being conditioned by the capacitance.

11. The semiconductor device of claim 10, wherein the at least one second electrode includes a backplate (612) keeping in place the deformable membrane (678) through at least one support post (675).

12. The semiconductor device (1000, 1100, 1200) of any of claims 1-9, wherein deformable membrane includes a piezoelectric layer (1030a, 1030b, 1030c) electrically connected to the at least one electric contact (51a, 51b), the deformation of the piezoelectric layer being conditioned by the movement of the at least one mass element (22), causing the variation of the electric signal (52).

13. A sensor device (800) comprising the semiconductor device of any of the preceding claims, further comprising:

    analog-to-digital circuitry (54) to convert the electric signal (52) indicative of the deformation of the deformable membrane (12) onto a digital version (53); and
    at least one digital measurer (56) to obtain, from the digital version (53) of the electric signal (52), a measurement (58) of at least one pressure, vibration, and acceleration.

14. A method for manufacturing a semiconductor device, the method comprising:

making a support structure (60) and a deformable membrane (12) supported by the support structure (60) through at least one supporting connection, in such a way that the at least one supporting connection includes at least one elastic connection, the at least one mass element (22, 222, 322, 22a, 22d) being attached to, or integral with, the deformable membrane (12); and

electrically connecting the deformable membrane (12) to a circuitry (50), the circuitry being configured to acquire an electric signal (52) indicative of the deformation of the deformable membrane (12) conditioned by the movement of the at least one mass element (22, 222, 322, 22a, 22d).

15. The method of claim 14, wherein at least one mass element (322) is obtained through metal plating.

16. The method of claim 14 or 15, wherein the semiconductor device includes a capacitor (40) with variable capacitance, the capacitor (40) having a first electrode and second electrode (42), the first electrode including deformable membrane (12),
the method including making the second electrode (42) before, and in a more internal position than, deformable membrane (12), the method including making the at least one mass element (22) more external than the deformable membrane.

Fig. 1a

Fig. 1b

Fig. 2

Fig. 3

Fig. 4b

Fig. 4c

Fig. 4a

EP 4 296 221 A1

Fig. 4d

Fig. 4e

Fig. 4f

Fig. 5a

Fig. 5b

Fig. 6a

EP 4 296 221 A1

Fig. 6b

Fig. 7

Fig. 8a

EP 4 296 221 A1

Fig. 8b

100, 200, 300, 800

60b

42

630

70

22

12

60a

630a

60

Fig. 9

Fig. 10a

Fig. 10b

Fig. 11a

Fig. 11b

piezoelectric layer

1200

1034' 1035b'

1032

1030c
1030d

60'

1222

70

1035b"

22

1034b"

70

60'

60"

Fig. 12

42

40{

12, 1022, 1122, 1222

524

Fig. 13a

100, 200, 300, 800...

42

}40

70

12, 1022, 1122, 1222

22, 322

526

Fig. 13b

12, 1022, 1122, 1222

70

**Fig. 14a**

12, 1022, 1122, 1222

70

70

70

70

**Fig. 14b**

600

612  42'  675  640

678  613  675'

622  60a  60

Fig. 15a

600

70  70

678  612  622

612

Fig. 15b

Europäisches
Patentamt

European
Patent Office

Office européen
des brevets

# EUROPEAN SEARCH REPORT

Application Number

EP 22 18 0506

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/037310 A1 (SETO MASAMI [JP]) 15 February 2007 (2007-02-15) | 1,2,7-9, 12-14 | INV. B81B3/00 |
| Y | * paragraphs [0053] - [0056] * * figure 2B * | 5 | |
| X | US 2006/272413 A1 (VAGANOV VLADIMIR [US] ET AL) 7 December 2006 (2006-12-07) * paragraphs [0082], [0098], [0099], [0100], [0106], [0126], [0130] * * figure 2 * | 1-3,8,9, 12,13 | |
| X | US 2016/023244 A1 (ZHUANG XUEFENG [US] ET AL) 28 January 2016 (2016-01-28) | 1,14 | |
| Y | * paragraphs [0038], [0039], [0041], [0053] * * figure 10A * | 6,15 | |
| Y | CN 213 818 178 U (KNOWLES ELECTRONICS SUZHOU CO LTD) 27 July 2021 (2021-07-27) * paragraph [0029] * * figures 1,2 * | 5 | |
| | | | TECHNICAL FIELDS SEARCHED (IPC) |
| Y | US 2012/234093 A1 (BLACK JUSTIN PHELPS [US] ET AL) 20 September 2012 (2012-09-20) * paragraph [0025] * | 6,15 | B81B H04R |
| Y | US 2015/014796 A1 (DEHE ALFONS [DE]) 15 January 2015 (2015-01-15) * paragraphs [0045], [0087] - [0091] * * figures 1a,1b,9a,9b * | 4 | |
| X | US 2022/155073 A1 (DENG KEN [US] ET AL) 19 May 2022 (2022-05-19) | 1,10,11, 16 | |
| Y | * paragraphs [0042], [0047], [0048], [0029], [0052], [0055] * * figures 8,9 * | 4 | |

The present search report has been drawn up for all claims

| Place of search | Date of completion of the search | Examiner |
|---|---|---|
| Berlin | 26 January 2023 | Foussier, Philippe |

EPO FORM 1503 03.82 (P04C01)

Europäisches
Patentamt

European
Patent Office

Office européen
des brevets

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

**see sheet B**

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

## LACK OF UNITY OF INVENTION
### SHEET B

The Search Division considers that the present European patent application does not comply with the requirements of unity of invention and relates to several inventions or groups of inventions, namely:

```
1. claims: 1-3, 5-9, 12-15

      Semiconductor device with a mass element having specific
      geometries or material
                            ---


2. claim: 4

      Seiconductor device comprising at least one flap
                            ---


3. claims: 10, 11, 16

      Semiconductor device comprising a capacitor
                            ---
```

## ANNEX TO THE EUROPEAN SEARCH REPORT
## ON EUROPEAN PATENT APPLICATION NO.

EP 22 18 0506

This annex lists the patent family members relating to the patent documents cited in the above-mentioned European search report.
The members are as contained in the European Patent Office EDP file on
The European Patent Office is in no way liable for these particulars which are merely given for the purpose of information.

26-01-2023

| Patent document cited in search report | | | Publication date | Patent family member(s) | | Publication date |
|---|---|---|---|---|---|---|
| US 2007037310 | A1 | | 15-02-2007 | JP | 4688600 B2 | 25-05-2011 |
| | | | | JP | 2007033355 A | 08-02-2007 |
| | | | | US | 2007037310 A1 | 15-02-2007 |
| US 2006272413 | A1 | | 07-12-2006 | NONE | | |
| US 2016023244 | A1 | | 28-01-2016 | US | 2016023244 A1 | 28-01-2016 |
| | | | | US | 2018085785 A1 | 29-03-2018 |
| CN 213818178 | U | | 27-07-2021 | CN | 113518292 A | 19-10-2021 |
| | | | | CN | 213818178 U | 27-07-2021 |
| US 2012234093 | A1 | | 20-09-2012 | CN | 103430340 A | 04-12-2013 |
| | | | | JP | 6184874 B2 | 23-08-2017 |
| | | | | JP | 2014517256 A | 17-07-2014 |
| | | | | JP | 2016138890 A | 04-08-2016 |
| | | | | KR | 20140012138 A | 29-01-2014 |
| | | | | KR | 20160045921 A | 27-04-2016 |
| | | | | TW | 201310734 A | 01-03-2013 |
| | | | | US | 2012234093 A1 | 20-09-2012 |
| | | | | WO | 2012125503 A1 | 20-09-2012 |
| US 2015014796 | A1 | | 15-01-2015 | CN | 104284290 A | 14-01-2015 |
| | | | | DE | 102014213386 A1 | 15-01-2015 |
| | | | | KR | 20150007988 A | 21-01-2015 |
| | | | | US | 2015014796 A1 | 15-01-2015 |
| US 2022155073 | A1 | | 19-05-2022 | NONE | | |

EPO FORM P0459

For more details about this annex : see Official Journal of the European Patent Office, No. 12/82